# EUROPEAN PATENT SPECIFICATION

(11) **EP 1 641 122 B1**
(45) Date of publication and mention of the grant of the patent: **05.08.2009**
(21) Application number: 05020546.7
(22) Date of filing: 21.09.2005
(51) Int. Cl.: H03K 17/96

(54) **Cook top control pad**
Steuereinrichtung für ein Kochfeld
Dispositif de commande pour des plaques de cuisson

(30) Priority: 22.09.2004 IT BO20040077
(43) Date of publication of application: 29.03.2006
(73) Proprietor: SELTA S.r.l., 40050 Calderino Di Monte S. Pietro BO (IT)
(72) Inventor: Rabotti, Tommaso, 48100 Ravenna (IT)
(74) Representative: Dall'Olio, Giancarlo

(56) References cited:
- EP-A- 1 273 851
- EP-A1- 0 443 924
- DE-C1- 19 817 195
- US-A1- 5 867 111

## Description

The present invention relates to the technical field concerning electronic devices applied to the tops for cooking dishes, e.g. by electric means, with particular reference to the devices including capacitive technology keypads.

As far as electric, and not only electric, cook tops are concerned, the so-called "touch control" systems are widespread, having a hardware part and a software part, which detects the contact of a finger with a cook top, the latter usually made of ceramic glass, and which carry out the operations determined by complicated algorithms contained therein, to control the supplying of electric heating elements by a power group.

More in detail, a cook top made of ceramic glass is a smooth surface, which has relative marks, in place of the traditional push-buttons, situated in its upper part, on one side.

Electric heating elements are situated below the cook top, and a hardware interface is situated in zones corresponding to the tracks, for identifying the contact between an object and the above mentioned touch-"push-buttons" and for transmitting the associated information to a process and control unit.

Each signal coming from the touch-keypad, therefore representing a relevant touch-button, is analyzed in the above mentioned unit, by a complicated software algorithm, capable of recognizing a user's voluntary action and the placing of, or contact with, any other object.

Finally, due to the above recognition, the computation program defines the signals, which operate the power group to turn on the relative heating elements.

In particular, the above mentioned hardware touch-pad is an optical, or capacitive technology touch-pad.

The first solution, which is expensive and complicated to apply, includes the emission of infrared beams, each of which covers the area of a relative touch-button, and the consequent recognition, by reflection, of any object touching this area.

For this purpose, there are sensor means, which receive the reflected beam, supplying an associated signal, destined to the process unit.

Otherwise, the second solution recognizes the human finger as a ground conductor, allowing to identify the user's intention to interact with the touch-pad in a simpler and more effective way.

Therefore, the use of capacitive technology touch-pads allows the relevant process and control unit to be developed by simplifying its hardware and software parts, which causes a sensible costs reduction, and consequently a wider distribution on the market.

At present, the capacitive touch-pads are mounted adhering strictly .to the cook top, made of ceramic glass, and in positions corresponding to the relevant marks made thereon.

The touch-pads have a first section, which generates and sends first signals to the process and control unit, included in a suitable integrated card.

The group formed by the touch-pad and the above process and control unit forms a control panel of non-acceptable dimensions, taking into consideration the increasing demand for smaller devices of new generation. It is also to be pointed out that high temperatures and pressures, to which the top of ceramic glass is subjected, e.g. during the cooking of dishes, causes its bending, which can become considerable in time.

For functional reasons, the upper surface of the touch-pad must follow the glass curvature, in order to maintain the right adherence in all points.

This is obtained by supporting the touch-pad with a self-leveling system, fastened to the framework and formed by "gums", that is elements of gummy material of low elastic yielding, which in most unfavorable cases do not assure the adherence of the touch-pad to the glass.

Moreover, an incorrect installation can cause overpressures of the touch-pad on the top of ceramic glass, thus determining its premature bending.

German patent n. DE 198 17 195 C discloses an arrangement comprising a cooking field in a cooking field mount of a work plate with a cooking plate of glass-ceramic or similar with contact surfaces of an operating region on the upper side of the cooking plate, which are monitored by sensors, which are arranged below the cooking plate, of an operating unit of the cooking field, which is disposed in connection with a control unit of the cooking field, for controlling the heating elements, arranged below the cooking plate.

The object of the present invention is to propose a cook top control pad, which is compact, whose dimensions are small, and which is relatively cheap in comparison with known solutions.

Another object of the present invention is to propose a cook top control pad, whose installation is simple, and which maintains in time a constant adherence to the cook top also when the latter bends to a bigger or smaller extent, maintaining its functionality intact.

The above mentioned objects are obtained in accordance with the contents of the claims.

The characteristic features of the invention, which do not result from what has just been said, will be pointed out in the following, in accordance with claims and with help of the enclosed figures, in which:

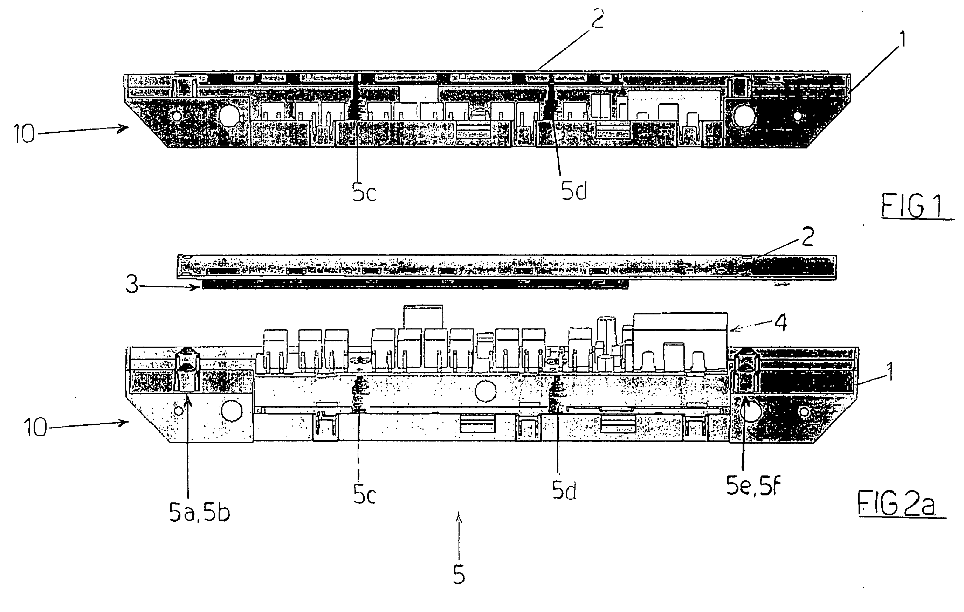

- Figure 1 is a front view of a "touch control" system;

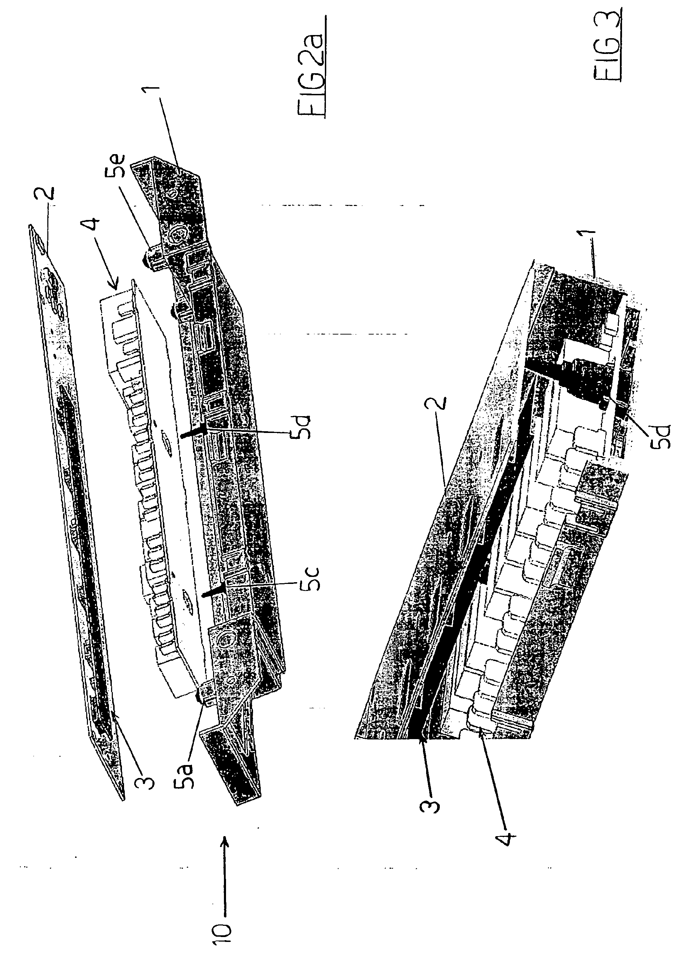

- Figures 2a, 2b are exploded views of the same system, in two different perspective views, which show the control pad proposed by the present invention;
- Figure 3 is a prospective view of a detail of the above mentioned "touch control" system.

With reference to the enclosed Figures, the reference numeral 10 indicates a so-called "touch control" system, including a support 1 fastened to a framework, not shown, a capacitive touch-pad 2, integrating a first unit for generating electric signals, not shown, a process and control unit 3, a power group 4 and a self-leveling system 5.

The self-leveling system 5 includes a plurality of support pins 5a, 5b, 5c, 5d, 5e, 5f, oriented vertically, each of which has a defined elastic yielding, and which are carried by the support 1, to hold the capacitive touch-pad 2.

The support pins include e.g. a casing, containing at least one spring.

A cook top, e.g. of ceramic glass, not shown, carries a plurality of marks, generally defining boxes and the like.

The upper part of the capacitive touch-pad 2 adheres to the cook top and its lower part includes the above mentioned first unit and process and control unit 3, connected electrically.

The power group 4 is fastened to the support 1 and connected electrically, in known and not shown way, to the process and control unit 3 and to a plurality of electric heating elements, not shown, since known.

Now the operation of the cook top control pad proposed by the present invention will be described.

As it has been specified, the cook top has a plurality of marks depicting a certain number of boxes, which represent, in equivalent terms, push-buttons, which are activated, when touched by the user.

The activation of a touch-button generates, in the first unit, a corresponding electric signal, which is sent to the process and control unit 3 to be processed according to a prefixed calculation algorithm.

The computation program determines the generation of second signals, which leave the process and control unit 3 and adjust the flow of current circulating through the electric heating elements by the power group 4.

The capacitive touch-pad 2 allows to distinguish the user's action from the contact or placing of an object of any shape over a touch-button; precisely, each box defines a dielectric and an armature, which are portions of the cook top and of the upper surface of the touch-pad 2, respectively.

A finger touching the area included in this box forms a ground conductor, changing the so defined capacity.

This change is transformed in an electric signal by the first unit, as stated before.

In this way, it is possible to place a plurality of displays on the touch-pad 2, visible to the user through the ceramic glass, which allow setting, through the above mentioned touch-buttons, a clock, if included, a timer and the temperature, which one or more heating elements must reach.

Therefore, the capacitive touch-pad 2 integrates the whole hardware and software parts, which generate first signals representing operation of a button, distinguish significant signals from non- significant ones, and define second signals, which control the power group 4 and thus adjust the electric heating elements.

Consequently, the control pad, including, as already said in the introductory note, the touch-pad and the process and control unit, is an exclusive support, which carries the capacitive touch-pad 2, as well as the process and control unit 3.

All this is obtained with a considerable decrease of the dimensions with respect to known solutions, which results directly in reduction of the production costs.

The self-leveling system 5, applied to the capacitive touch-pad 2, allows a complete adherence of the upper surface of the capacitive touch-pad 2 to the cook top, also when the latter is bended, in time or due to an erroneous mounting, which causes a bigger or smaller concavity.

This is obtained by the elastic deformation, which the support pins 5a, 5b, 5c, 5d, 5e, 5f, forming said self-leveling system 5, can assume.

The support pins 5a, 5b, 5c, 5d, 5e, 5f are situated in such a way, as to exert almost equal forces in normal conditions, that is, when the cook top has a perfectly flat surface.

Consequently, in case of the cook top deformation, the self-leveling system will keep constant the adherence of the touch-pad 2, due to the elastic yielding of each support pin.

Anyway, the elastic force performed by each support pin is such, as not to put at risk the integrity of the touch-pad 2 in any way.

An advantage of the present invention lies in the fact that it proposes a cook top control pad of minimum dimensions, smaller than known control pads, which results in a considerable reduction of production costs.

Another advantage of the present invention lies in the fact that it proposes a cook top control pad, which is simple to assemble and which can maintain, in time, a constant adherence to the cook top also when the latter bends to a bigger or smaller extent, maintaining intact its functionality.

## Claims

1. Cook top control pad, of the type including:
- a capacitive touch-pad (2), whose thickness is limited with respect to its other dimensions, and which is associated to a framework, with the upper part of the touch-pad (2) touching a related cook top, and the lower part thereof provided with a first unit for generating first electric signals, resulting from placing at least one hand finger of a user in prefixed areas of the upper surface of said cook top;
- a process and control unit (3), connected electrically to said first unit, which receives from the latter said first signals, which processes them, and which supplies second signals, depending on the first ones, for controlling a power group (4) for supplying electric heating elements, said process and control unit (3) being situated in the lower side of said capacitive touch-pad (2);
**characterized in that** the lower part of the capacitive touch pad (2) includes the process and control unit (3), so as to provide an exclusive support, which carries the capacitive touch-pad (3), as well as the process and control unit (3).

2. Pad, as claimed in claim 1, **characterized in that** it includes a self-leveling system (5), which has one side fastened to said framework and the other side supporting said capacitive touch-pad (2).

3. Pad, as claimed in claim 2, **characterized in that** said self-leveling system (5) includes a plurality of support pins having a selected elastic yielding.

4. Pad, as claimed in claim 3, **characterized in that** said support pins are oriented vertically.

5. Pad, as claimed in claim 3, **characterized in that** each of said support pins includes a casing, containing at least one spring.

## Patentansprüche

1. Steuereinrichtung für ein Kochfeld, umfassend:
eine kapazitive Berührungseinrichtung (2), deren Dicke in Bezug auf ihre anderen Abmessungen begrenzt ist, und die einer Struktur zugehörig ist, wobei der obere Teil der Berührungseinrichtung (2) ein zugehöriges Kochfeld berührt, und der untere Teil davon mit einer ersten Einheit zum Erzeugen erster elektrischer Signale versehen ist, die vom Platzieren mindestens eines Fingers eines Benutzers in zuvor festgelegten Bereichen der oberen Fläche des Kochfelds herrühren;
eine Prozess- und Steuereinheit (3), die elektrisch an die erste Einheit angeschlossen ist, die von der Letzteren die ersten Signale empfängt, die sie verarbeitet, und die zweite Signale liefert, abhängig von den ersten, zum Steuern einer Leistungsgruppe (4) zum Versorgen elektrischer Wärmeelemente, wobei sich die Prozess- und Steuereinheit (3) in der unteren Seite der kapazitiven Berührungseinrichtung (2) befindet;
**dadurch gekennzeichnet, dass** der untere Teil der kapazitiven Berührungseinrichtung (2) die Prozess- und Steuereinheit (3) umfasst, um eine ausschließliche Abstützung bereit zu stellen, die die kapazitive Berührungseinrichtung (3) sowie die Prozess- und Steuereinheit (3) trägt.

2. Einrichtung nach Anspruch 1, **dadurch gekennzeichnet, dass** sie ein selbstausgleichendes System (5) umfasst, deren eine Seite an der Struktur befestigt ist und deren andere Seite die kapazitive Berührungseinrichtung (2) stützt.

3. Einrichtung nach Anspruch 2, **dadurch gekennzeichnet, dass** das selbstausgleichende System (5) eine Mehrzahl Stützstifte umfasst, die eine ausgewählte elastische Nachgiebigkeit aufweist.

4. Einrichtung nach Anspruch 3, **dadurch gekennzeichnet, dass** die Stützstifte vertikal ausgerichtet sind.

5. Einrichtung nach Anspruch 3, **dadurch gekennzeichnet, dass** jeder der Stützstifte ein Gehäuse umfasst, das mindestens eine Feder umfasst.

## Revendications

1. Pavé de commande de plaque de cuisson, du type comprenant:
- un pavé tactile capacitif (2), dont l'épaisseur est limitée par rapport à ses autres dimensions, et qui est associé à un cadre, la partie supérieure du pavé tactile (2) touchant une plaque de cuisson associée, et la partie inférieure de celui-ci étant dotée d'une première unité destinée à générer des premiers signaux électriques suite au positionnement d'au moins un doigt d'une main d'un utilisateur sur des zones définies au préalable de la surface supérieure de ladite plaque de cuisson ;
- une unité de traitement et de commande (3), connectée de manière électrique à ladite première unité, qui reçoit en provenance de cette dernière lesdits premiers signaux, qui les traite, et qui fournit des seconds signaux qui dépendent des premiers signaux, destinés à commander un groupe d' alimentation (4) destiné à alimenter les éléments chauffants électriques, ladite unité de traitement et de commande (3) étant située du côté inférieur dudit pavé tactile capacitif (2) ;
**caractérisé en ce que** la partie inférieure du pavé tactile capacitif (2) comprend l'unité de traitement et de commande (3), de manière à fournir un support exclusif qui porte le pavé tactile capacitif (3), ainsi que l'unité de traitement et de commande (3).

2. Pavé, selon la revendication 1, **caractérisé en ce qu'**il comprend un système de mise à niveau automatique (5), dont un côté est fixé audit cadre, et l'autre côté supporte ledit pavé tactile capacitif (2).

3. Pavé, selon la revendication 2, **caractérisé en ce que** ledit système de mise à niveau automatique (5) comprend une pluralité de broches de support qui présentent une flexion élastique sélectionnée.

4. Pavé, selon la revendication 3, **caractérisé en ce que** lesdites broches de support sont orientées de manière verticale.

5. Pavé, selon la revendication 3, **caractérisé en ce que** chacune desdites broches de support comprend une enveloppe qui contient au moins un ressort.
